(19) Europäisches Patentamt
European Patent Office
Office européen des brevets

(11) **EP 2 284 383 A2**

(12) **EUROPÄISCHE PATENTANMELDUNG**

(43) Veröffentlichungstag:
**16.02.2011 Patentblatt 2011/07**

(51) Int Cl.:
**F02M 25/07** (2006.01)

(21) Anmeldenummer: **10006233.0**

(22) Anmeldetag: **16.06.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(30) Priorität: **12.08.2009 DE 102009037179**

(71) Anmelder: **Bayerische Motoren Werke Aktiengesellschaft**
**80809 München (DE)**

(72) Erfinder:
• **Neugebauer, Stephen, Dr.**
**82441 Ohlstadt (DE)**
• **Eder, Andreas, Dr.**
**80809 München (DE)**
• **Linde, Matthias, dr.**
**81243 München (DE)**
• **Mazar, Boris**
**80807 München (DE)**

(54) **Abgasführungsvorrichtung für eine Brennkraftmaschine mit einem thermoelektrischen Generator**

(57) Es wird eine Abgasführungsvorrichtung für eine Brennkraftmaschine mit einem thermoelektrischen Generator (17) mit einer Mehrzahl von thermoelektrischen Modulen (16) vorgeschlagen, die zwischen einer vom Abgas erwärmten ersten Fläche (18) und einer von Kühlmittel gekühlten zweiten Fläche (21) angeordnet sind, wobei in Strömungsrichtung des Abgases Module (16) mit thermoelektrischem Material mit unterschiedlicher Ladungsträgerdichte vorgesehen sind.

FIG. 1

EP 2 284 383 A2

**Beschreibung**

Die vorliegende Erfindung betrifft eine Abgasführungsvorrichtung für eine Brennkraftmaschine mit einem thermoelektrischen Generator mit einer Mehrzahl von thermoelektrischen Modulen, die zwischen einer vom Abgas erwärmten ersten Fläche und einer von Kühlmittel gekühlten zweiten Fläche angeordnet sind, nach dem Oberbegriff des Anspruchs 1. Die Erfindung betrifft darüber hinaus ein Verfahren zur Bildung eines thermoelektrischen Generators mit einer Mehrzahl thermoelektrischer Module, die zwischen mit unterschiedlichen Temperaturen beaufschlagbaren Flächen angeordnet sind, nach dem Oberbegriff des Anspruchs 6.

Im Zuge der Energieeinsparung ist es bei Fahrzeugen mit Brennkraftmaschinen bereits bekannt geworden, thermoelektrische Generatoren im Abgasstrang vorzusehen, die thermische Energie in elektrische Energie umwandeln. Die so gewonnene elektrische Energie kann dann beispielsweise dazu verwendet werden, elektrische Antriebe im Fahrzeug zu betreiben. Auf diese Weise kann eine Brennstoffersparnis erreicht werden, da die elektrische Energie nicht generatorisch mittels der Brennkraftmaschine bereitgestellt werden muss.

Anhand der DE 10 2005 005 077 A1 ist ein thermoelektrischer Generator für eine Brennkraftmaschine bekannt geworden. Bei diesem bekannten thermoelektrischen Generator soll eine Beschädigung der Generatorelemente dadurch vermieden werden, dass diese relativ zu einem Kühlmechanismus und zu einer Hülse bewegbar angeordnet sind.

Anhand der US PS 960,324 ist ein thermoelektrisches Generatormodul bekannt geworden, welches insbesondere zur Verwendung unter hohen Temperaturen geeignet sein soll.

Schließlich ist anhand der DE 10 2006 019 282 A1 ein Abgasrückführsystem für eine Brennkraftmaschine bekannt geworden, welches auf die Anmelderin zurückgeht. Obwohl sich dieses bekannte Abgasrückführsystem und der dort vorgesehene thermoelektrische Generator bereits bestens bewährt haben, ist noch Raum für Verbesserungen vorhanden dahingehend, dass die Leistung des thermoelektrischen Generators verbessert werden kann.

Die vom thermoelektrischen Generator rekuperierte elektrische Leistung hängt stark von der Temperaturdifferenz zwischen der heißen Seite und der kalten Seite der thermoelektrischen Module ab. Zur Verbesserung der Leistung wird eine möglichst gleichmäßige und hohe Temperatur an der heißen Seite angestrebt.

Wird das heiße Abgas über die heiße Seite geleitet, so verliert es zwangsläufig thermische Energie und es kommt zu einem Temperaturgradienten in Durchströmungsrichtung des thermoelektrischen Generators. Zum Ausgleich dieses Temperaturabfalls ist es bekannt geworden, den Wärmeübergangskoeffizienten in Durchströmungsrichtung des Generators zu erhöhen. Zu diesem Zweck wird beispielsweise die Berippung der heißen Seite erhöht, die Stirnflächen der Rippen erzeugen Turbulenzzonen und die Wärme übertragende Fläche zwischen dem Abgas und der heißen Fläche des Generators nimmt zu, beides trägt dazu bei, die Wärmeübertragung vom Abgas auf die heiße Seite der thermoelektrischen Module zu verbessern und die lokale Temperatur auf der Modulheißseite anzuheben.

Der auf eine Wärme übertragende Basisfläche bezogene Wärmeübergangskoeffizient ist folgendermaßen definiert:

$$\alpha^* = \alpha_{Basis} \frac{\eta_{Finne} \cdot A_{Finne} + A_{Basisfläche}}{A_{Basisfläche}}$$

mit:

| | |
|---|---|
| $\alpha_{Basis}$: | Wärmeübergangskoeffizient der Fläche |
| $\eta_{Finne}$: | Finnenwirkungsgrad, Verhältnis zwischen tatsächlichem Wärmestrom, der über die Finnenoberfläche übertragen wird zu maximal möglichem Wärmestrom bei einer idealen Wärmeleitfähigkeit |
| $A_{Finne}$: | Finnenoberfläche |
| $A_{Basisfläche}$: | Fläche eines Referenzabschnitts der Wärme übertragenden ersten Fläche |

Über die Vergrößerung der Anzahl der Finnen in Durchströmungsrichtung der Wärme übertragenden Fläche kann der auf die Basisfläche bezogene Wärmeübergangskoeffizient erhöht werden.

Die sich real einstellende Temperaturdifferenz zwischen der heißen Seite und der kalten Seite des thermoelektrischen Moduls hängt zusätzlich aber auch von der Wärmeleitfähigkeit des thermoelektrischen Materials für die sich einstellenden Temperaturbereiche ab.

Im Eintrittsbereich eines thermoelektrischen Generators ist das Temperaturniveau des Abgases hoch und die Temperatur sinkt in Durchströmungsrichtung ab, was, wie vorstehend schon erwähnt, durch eine graduell in Durchströmungsrichtung stärker werdende Berippung der heißen Seite ausgeglichen werden kann. Dadurch steigt in Durchströmungsrichtung aber auch der auf die Basisfläche bezogene Wärmeübergangskoeffizient an. Der Wärmeübergangskoeffizient aber bestimmt in wesentlicher Weise die Leistungsfähigkeit der thermoelektrischen Module.

Der vorliegenden Erfindung liegt die Aufgabe zu Grunde, eine verbesserte Abgasführungsvorrichtung mit erhöhter elektrischer Leistung des thermoelektrischen Generators zu schaffen. Auch soll ein Verfahren zur Bildung eines solchen thermoelektrischen Generators angegeben werden.

Die Erfindung weist zur Lösung dieser Aufgabe hinsichtlich der Abgasführungsvorrichtung die im Anspruch 1 angegebenen Merkmale auf, vorteilhafte Ausgestaltungen hiervon sind in den weiteren Ansprüchen beschrieben. Darüber hinaus weist die Erfindung hinsichtlich des Verfahrens die im Anspruch 6 angegebenen Merkmale auf.

Die Erfindung schlägt eine Abgasführungsvorrichtung für eine Brennkraftmaschine mit einem thermoelektrischen Generator mit einer Vielzahl von thermoelektrischen Modulen vor, die zwischen einer vom Abgas erwärmten ersten Fläche und einer von Kühlmittel gekühlten zweiten Fläche angeordnet sind und in Strömungsrichtung des Abgases Module mit thermoelektrischem Material mit unterschiedlicher Ladungsträgerdichte vorgesehen sind.

Die Erfinder haben erkannt, dass sich in Abhängigkeit des Wärmeübertragungskoeffizienten die Größe des Einflusses der Wärmeleitfähigkeit und der elektrischen Leitfähigkeit des thermoelektrischen Materials, aus dem die thermoelektrischen Module des Generators gebildet sind, auf die Leistungsfähigkeit des Generators ändert. Der elektrische Anteil der Wärmeleitfähigkeit und die elektrische Leitfähigkeit hängen jedoch direkt über das Wiedemann-Franzsche-Gesetz zusammen. Eine Veränderung der Ladungsträgerdichte beeinflusst zwangsläufig beide Materialeigenschaften. Eine im thermoelektrischen Sinne Verschlechterung der einen Eigenschaft geschieht zeitgleich mit einer Verbesserung der anderen.

Unterhalb eines vorbestimmten Schwellenwerts des auf die Basisfläche bezogenen Wärmeübertragungskoeffizienten $\alpha^*$ führt eine Verringerung der elektrischen Leitfähigkeit und der thermische Leitfähigkeit zu einem Anstieg der elektrischen Leistung eines thermoelektrischen Moduls oder Schenkelpaares, während oberhalb des vorbestimmten Schwellenwerts eine Vergrößerung der elektrischen und der thermischen Leitfähigkeit zu einer Erhöhung der vom Schenkelpaar abgegebenen elektrischen Leistung führt.

Um nun diesem Einfluss gerecht zu werden, schlagen die Erfinder die vorstehend erwähnte Abgasführungsvorrichtung vor, die thermoelektrische Schenkelpaare beziehungsweise Module aufweist, die ein thermoelektrisches Material besitzen, welches in Strömungsrichtung des Abgases unterschiedliche Ladungsträgerdichte aufweist. Dies kann durch den Einsatz eines einheitlichen thermoelektrischen Basismaterials erreicht werden, bei dem in Abhängigkeit vom konvektiven Wärmewiderstand die Ladungsträgerdichte durch entsprechende Dotierung angepasst wird.

Damit wird nach der vorliegenden Erfindung eine Beeinflussung der thermischen und elektrischen Leitfähigkeit des thermoelektrischen Materials erreicht, das zur Bildung der Schenkelpaare herangezogen wird.

Die elektrische und thermische Leitfähigkeit kann durch eine entsprechende Dotierung des thermoelektrischen Materials beeinflusst werden, welches zur Bildung der Schenkelpaare verwendet wird. Werden also im Gegensatz zu bekannten Abgasführungsvorrichtungen, die Schenkelpaare mit in Strömungsrichtung des Abgases gleicher Ladungsträgerdichte aufweisen, Schenkelpaare oder Module eingesetzt, deren Ladungsträgerdichte entsprechend des Wärmeübertragungskoeffizienten $\alpha^*$ unterschiedliche Ladungsträgerdichten aufweisen, kann die vom thermoelektrischen Generator rekuperierte elektrische Leistung deutlich erhöht werden.

Die Erfindung sieht nun nach einer Weiterbildung eine Abgasführungsvorrichtung vor, deren erste Fläche derart konfiguriert ist, dass ein konvektiver Wärmeübergangswiderstand zwischen dem Abgas und der ersten Fläche in Strömungsrichtung des Abgases abnimmt und der auf die Basisfläche bezogene Wärmeübergangskoeffizient $\alpha^*$ ansteigt, wobei in Strömungsrichtung des Abgases vor einem Bereich der Abgasführungsvorrichtung mit einem vorbestimmten Schwellenwert des Wärmeübergangswiderstands Module mit niedriger Ladungsträgerdichte vorgesehen sind und nach dem Bereich mit vorbestimmten Schwellenwert Module mit hoher Ladungsträgerdichte vorgesehen sind.

Dadurch wird in vorteilhafter Weise erreicht, dass das thermoelektrische Material der Schenkelpaare oder Module vor dem Bereich mit dem Schwellenwert des Wärmeübergangswiderstands eine niedrige elektrische und thermische Leitfähigkeit besitzt.

Wird zum Vergleich ein Referenzmaterial herangezogen, welches eine vorbestimmte elektrische und thermische Leitfähigkeit besitzt, ist es nach der Erfindung vorgesehen, dass das thermoelektrische Material in Strömungsrichtung des Abgases durch die Abgasführungsvorrichtung hindurch vor dem Bereich mit dem vorbestimmten Schwellenwert des Wärmeübergangswiderstands eine solche Dotierung besitzt, dass die elektrische und thermische Leitfähigkeit des thermoelektrischen Materials verglichen mit dem Referenzmaterial niedriger ist und die elektrische und thermische Leitfähigkeit des thermoelektrischen Materials in Strömungsrichtung des Abgases nach dem Bereich mit dem vorbestimmten Schwellenwert des Wärmeübergangswiderstands höher ist als diejenige des Referenzmaterials.

Damit kann eine Abgasführungsvorrichtung geschaffen werden, die verglichen mit einer thermoelektrisches Referenzmaterial aufweisenden Abgasführungsvorrichtung bei ansonsten gleichen Randbedingungen ein deutlich erhöhtes Niveau der rekuperierbaren elektrischen Leistung aufweist.

Um an der vom Abgas erwärmten ersten Fläche der erfindungsgemäßen Abgasführungsvorrichtung ein möglichst gleichmäßiges Temperaturniveau einzustellen, ist es nach einer Weiterbildung der Erfindung vorgesehen, dass die Wärme übertragende Fläche der ersten Fläche in Strömungsrichtung des Abgases zunimmt.

Damit kann in Strömungsrichtung des Abgases der konvektive Wärmeübergangswiderstand graduell verringert werden. Durch die in Strömungsrichtung stattfindende Verringerung des Wärmeübergangswiderstands wird an einer vorbestimmbaren Stelle ein Schwellenwert des Wärmeübergangswiderstands und damit des Wärmeübergangskoeffizienten $\alpha^*$ erreicht, ab dem zur weiteren Verbesserung der elektrischen Leistungsfähigkeit des thermoelektrischen Generators die Ladungsträgerdichte durch Dotierung des thermoelektrischen Materials der Schenkelpaare vergrößert wird.

Zu diesem Zweck ist es nach einer Weiterbildung der Erfindung vorgesehen, dass das thermoelektrische Material derart dotiert ist, dass es stromaufwärts eines Bereichs der ersten Fläche mit vorbestimmten Wärmeübergangswiderstand eine niedrige elektrische und thermische Leitfähigkeit aufweist und stromabwärts des Bereichs eine hohe elektrische und thermische Leitfähigkeit besitzt. Damit besitzt das thermoelektrische Material eine einer Stufenfunktion ähnliche Ladungsträgerdichte.

Die Schenkelpaare des thermoelektrischen Generators werden in Strömungsrichtung des Abgases aus alternierend n- und p- dotiertem Material hergestellt. Die Erfindung sieht nun vor, dass das thermoelektrische Material stromabwärts eines Eintrittsbereichs des Abgases in die Abgasführungsvorrichtung sowie eines Bereichs der ersten Fläche mit einem Wärmeübergangswiderstand kleiner als einem vorbestimmten Schwellenwert mit einer höheren Majoritätsladungsträgerdichte versehen ist als im Bereich mit höherem Wärmeübergangswiderstand. Dadurch kann entsprechend dem in Strömungsrichtung des Abgases auftretenden Schwellenwert des Wärmeübergangswiderstands respektive des Wärmeübergangskoeffizienten $\alpha^*$ dem vorstehend erläuterten Einfluss der elektrischen beziehungsweise thermischen Leitfähigkeit auf die rekuperierbare elektrische Leistung pro Schenkelpaar Rechnung getragen werden.

Die Erfindung sieht auch ein Verfahren vor zur Bildung eines thermoelektrischen Generators mit einer Mehrzahl thermoelektrischer Module, die zwischen mit unterschiedlichen Temperaturen beaufschlagbaren Flächen angeordnet sind, wobei die Anordnung der Module so gewählt wird, dass die in Durchströmungsrichtung des Generators am Strömungsaustritt angeordneten Module eine höhere Ladungsträgerdichte besitzen als die am Strömungseintritt angeordneten Module.

Durch diese Anordnung besitzen die am Strömungseintritt angeordneten Module eine niedrigere elektrische und thermische Leitfähigkeit als die am Strömungsaustritt angeordneten Module. Im Bereich des Strömungseintritts des Generators kann durch eine niedrigere elektrische und thermische Leitfähigkeit die Rekuperationsfähigkeit der Module beziehungsweise Schenkelpaare erhöht werden, während im Bereich des Strömungsaustritts des Generators durch eine Erhöhung der thermischen und elektrischen Leitfähigkeit die Rekuperationsfähigkeit erhöht werden kann.

Die am Strömungseintritt angeordneten Module werden aus einem thermoelektrischen Material gebildet, welches so dotiert worden ist, dass die thermische und elektrische Leitfähigkeit abnimmt, während die am Strömungsaustritt angeordneten Module aus einem thermoelektrischen Material gebildet werden, welches zur Erhöhung der thermischen und elektrischen Leitfähigkeit entsprechend dotiert worden ist.

Damit kann der Erkenntnis Rechnung getragen werden, dass in einem Bereich mit vergleichsweise hohem Wärmeübertragungswiderstand durch eine Verringerung der thermischen und elektrischen Leitfähigkeit die Leistungsfähigkeit der Schenkelpaare beziehungsweise Module erhöht werden kann und in einem Bereich mit vergleichsweise niedrigem Wärmeübertragungswiderstand die Leistungsfähigkeit der Schenkelpaare beziehungsweise Module durch eine Erhöhung der thermischen elektrischen Leitfähigkeit verbessert werden kann.

Die Erfindung wird nachfolgend anhand der Zeichnung näher erläutert. Diese zeigt in:

Fig. 1 eine Darstellung eines Funktionsaufbaus eines Abgasrückführsystems mit einer Ausführungsform der erfindungsgemäßen Abgasführungsvorrichtung; und

Fig. 2 eine schematische Darstellung eines Ausschnitts aus dem Wandaufbau eines thermoelektrischen Generators mit in Durchströmungsrichtung zunehmender Berippung.

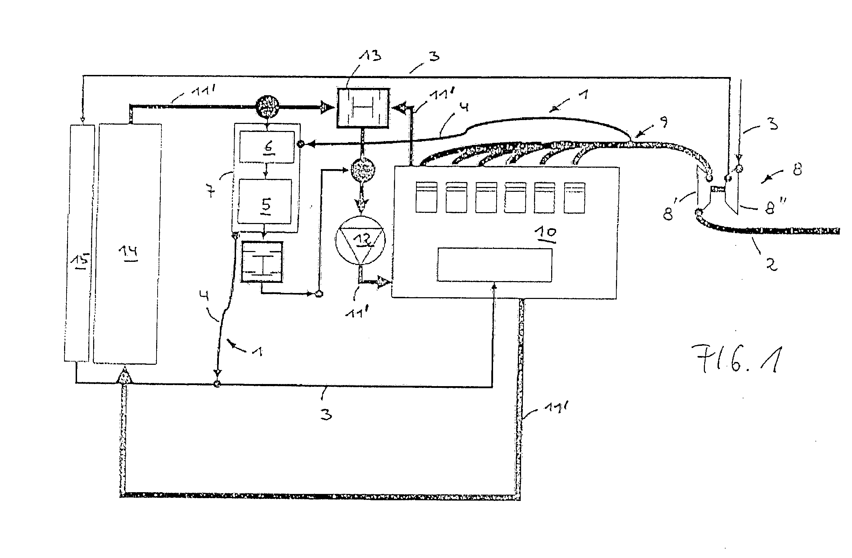

Fig. 1 der Zeichnung zeigt den Funktionsaufbau eines Abgasrückführsystems 1 für eine Brennkraftmaschine 10 mit in einem Gehäuse 7 angeordneten Abgasführungsvorrichtungen 6. Die Brennkraftmaschine 10 weist einen Abgasstrang 2 und einen Ansaugstrang sowie eine Ankoppelstelle 9 auf, an der beim Betrieb der Brennkraftmaschine 10 ein Teil des Abgases zur späteren Abgasrückführung entnommen wird.

Im Abgasstrang 2 ist eine Turbine 8' eines Turboladers 8 angeordnet, der einen Verdichter 8" im Frischluftstrang 3 antreibt. Der Verdichter 8" fördert Frischluft durch den Frischluftstrang 3 einem Ladeluftkühler 15 zu, von dem die Frischluft zur Brennkraftmaschine 10 gelangt. Das in der Brennkraftmaschine 10 entstehende Abgas wird über den Abgasstrang 2 ausgetragen.

Zur Kühlung besitzt die Brennkraftmaschine 10 einen Kühlmittelkreislauf 11'. Das von der Brennkraftmaschine 10 aufgeheizte Kühlmittel wird von einer Kühlmittelpumpe 12 einem Wärmeübertrager 14 zugeführt und anschließend durch ein Mischventil 13 wieder der Brennkraftmaschine 10 zugeleitet.

Der Abgasstrang 2 steht über eine Abgasleitung 4 mit dem Frischluftstrang 3 fluidisch in Verbindung, so dass zur Schadstoffbegrenzung Abgas in den Brennraum der Brennkraftmaschine 10 gefördert werden kann.

In einem Gehäuse 7 befinden sich eine Vielzahl von Abgasführungsvorrichtungen 6 und ein Abgaskühler 5 angeordnet, der stromabwärts der Abgasführungsvorrichtungen 6 vorgesehen ist. Die Abgasführungsvorrichtungen 6 weisen thermoelektrische Schenkelpaare 16 auf, die einen thermoelektrischen Generator ausbilden.

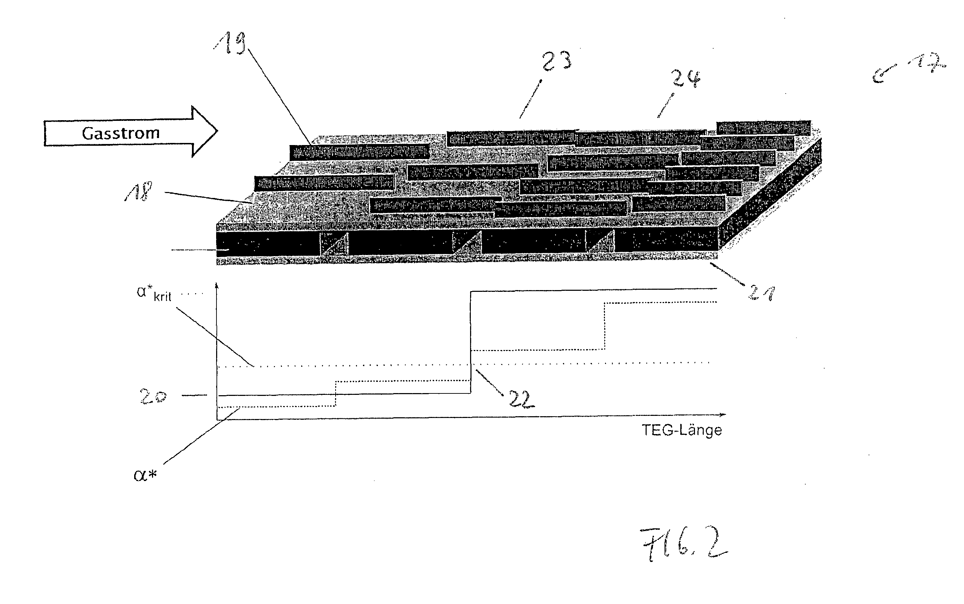

Fig. 2 der Zeichnung zeigt einen Ausschnitt eines Wandaufbaus eines thermoelektrischen Generators 17 mit thermoelektrischen Modulen beziehungsweise Schenkelpaaren 16.

Der Generator 17 besitzt eine erste Fläche 18, über die das heiße Abgas aus der Brennkraftmaschine 10 hinweg strömt. Um die Leistung des thermoelektrischen Generators 17 zu erhöhen, ist eine möglichst gleichmäßige und hohe Temperatur an der heißen ersten Fläche 18 erforderlich. Bei der Rekuperation aus dem Abgas der Brennkraftmaschine 10 kommt es durch den Entzug thermischer Energie zu einem Abfall der Temperatur in Durchströmungsrichtung des Gasstromes.

Zur Kompensation dieses Temperaturabfalls wird der Abgaswärmetauscher in Durchströmungsrichtung mit einer größer werdenden Zahl an Rippen 19 versehen, so dass die Wärmeübertragungsfläche im Bereich der ersten Fläche 18 in Richtung des Gasstromes zunimmt. Dadurch nimmt der Wärmeübertragungswiderstand zwischen dem Abgas und der ersten Fläche 18 in Durchströmungsrichtung ab.

Der konvektive Wärmeübergangswiderstand $R_{AG}$ ergibt sich anhand der Beziehung $R_{AG} = 1/(\alpha^* \cdot A_{Basisfläche})$, das heißt, mit abnehmendem Wärmeübergangswiderstand nimmt der auf die Basisfläche bezogene Wärmeübergangskoeffizient zu.

In Fig. 2 ist unterhalb des Wandaufbaus der Verlauf des auf die Basisfläche bezogenen Wärmeübergangskoeffizienten $\alpha^*$ dargestellt, der Wärmeübergangskoeffizient $\alpha^*$ steigt mit zunehmender Zahl der Rippen 19 an.

In dem Diagramm in Fig. 2 unterhalb des Wandaufbaus ist auch der Verlauf eines kritischen Wärmeübergangskoeffizienten $\alpha^*_{krit}$ dargestellt, der bei der dargestellten Ausführungsform einen Wert von etwa 500 $W/m^2K$ besitzt.

Solange der Wert des auf die Basisfläche bezogenen Wärmeübergangskoeffizienten $\alpha^*$ den kritischen Wärmeübergangskoeffizient $\alpha^*_{krit}$ noch nicht erreicht hat, befinden sich zwischen die erste Fläche 18 und einer beispielsweise mittels eines Kühlmittelstroms gekühlten zweiten Fläche 21 thermoelektrische Module 16 aus einem thermoelektrischen Material angeordnet, welches niedrige Ladungsträgerdichte besitzt.

In Fig. 2 ist dies in dem Diagramm mit der gleich bleibenden Ladungsträgerdichte 20 bis zu dem Punkt 22 dargestellt. Im Übergangsbereich von der zweiten Basisfläche 23 auf die dritte Basisfläche 24 erreicht der Wärmeübergangskoeffizient $\alpha^*$ den Wert des kritischen Wärmeübergangskoeffizienten $\alpha^*_{krit}$ und ab diesem Übergangsbereich würde die Beibehaltung des thermoelektrischen Materials, aus dem die thermoelektrischen Module 16 gebildet sind, dazu führen, dass die Rekuperationsfähigkeit der Module infolge der niedrigen thermischen und elektrischen Leitfähigkeit des thermoelektrischen Materials relativ abnimmt.

Der Verschlechterung der Rekuperationsfähigkeit wird dadurch entgegengetreten, dass ab diesem Übergangsbereich, an dem der Wärmeübergangskoeffizient größer als der kritische Wärmeübergangskoeffizient wird, die relative Ladungsträgerdichte des thermoelektrischen Materials der Module 16 erhöht wird.

Auf diese Weise wird dem Einfluss der elektrischen und thermischen Leitfähigkeit auf die Rekuperationsfähigkeit der thermoelektrischen Module 16 Rechnung getragen.

Bis zum Bereich des Schwellenwerts des Wärmeübergangskoeffizienten $\alpha^*_{krit}$ wird zur Bildung der thermoelektrischen Module 16 thermoelektrisches Material mit niedriger elektrischer und thermischer Leitfähigkeit verwendet, ab dem Bereich des Schwellenwerts wird nach der vorliegenden Erfindung thermoelektrisches Material mit hoher Majoritätsladungsträgerdichte eingesetzt.

Würde über die gesamte Längserstreckung des Generators 17 thermoelektrisches Material zur Bildung der thermoelektrischen Module 16 mit gleich bleibender Ladungsträgerdichte verwendet werden, so würde entweder im Bereich vor dem Schwellenwert weniger elektrische Leistung rekuperiert werden, oder im Bereich nach dem Schwellenwert, als dies nach der vorliegenden Erfindung möglich ist.

Bezugszeichenliste

| | |
|---|---|
| 1 | Abgasrückführsystem |
| 2 | Abgasstrang |
| 3 | Frischluftstrang |
| 4 | Abgasleitung |
| 5 | Abgaskühler |
| 6 | Abgasführungsvorrichtung |
| 7 | Gehäuse |
| 8 | Turbolader |
| 8' | Turbine |
| 8" | Verdichter |
| 9 | Ankoppelstelle |
| 10 | Brennkraftmaschine |
| 11' | Kühlmittelkreislauf |
| 12 | Kühlmittelpumpe |
| 13 | Mischventil |
| 14 | Wärmeübertrager |
| 15 | Ladeluftkühler |
| 16 | Schenkelpaare |
| 17 | Generator |
| 18 | erste Fläche |
| 19 | Rippen |
| 20 | Ladungsträgerdichte |
| 21 | zweite Fläche |
| 22 | Schnittpunkt, Bereich |
| 23 | zweite Basisfläche |
| 24 | dritte Basisfläche |

**Patentansprüche**

**1.** Abgasführungsvorrichtung für eine Brennkraftmaschine mit einem thermoelektrischen Generator (17) mit einer Mehrzahl von thermoelektrischen Modulen (16), die zwischen einer vom Abgas erwärmten ersten Fläche (18) und einer von Kühlmittel gekühlten zweiten Fläche (21) angeordnet sind, **dadurch gekennzeichnet, dass** in Strömungsrichtung des Abgases Module (16) mit thermoelektrischem Material mit unterschiedlicher Ladungsträgerdichte vorgesehen sind.

2. Abgasführungsvorrichtung nach Anspruch 1, **dadurch gekennzeichnet, dass** die erste Fläche (21) derart konfiguriert ist, dass ein konvektiver Wärmeübergangswiderstand zwischen dem Abgas und der ersten Fläche (18) in Strömungsrichtung des Abgases abnimmt und in Strömungsrichtung vor einem Bereich der Abgasführungsvorrichtung mit einem vorbestimmten Schwellenwert des Wärmeübergangswiderstands Module (16) mit niedriger Ladungsträgerdichte und nach dem Bereich Module (16) mit hoher Ladungsträgerdichte vorgesehen sind.

3. Abgasführungsvorrichtung nach Anspruch 2, **dadurch gekennzeichnet, dass** die Wärme übertragende Fläche der ersten Fläche (18) in Strömungsrichtung des Abgases zunimmt.

4. Abgasführungsvorrichtung nach einem der vorstehenden Ansprüche, **dadurch gekennzeichnet, dass** das thermoelektrische Material derart dotiert ist, dass es stromaufwärts eines Bereichs (22) der ersten Fläche (18) mit vorbestimmten Wärmeübergangswiderstand eine niedrige elektrische und thermische Leitfähigkeit aufweist und stromabwärts des Bereichs (22) eine hohe elektrische und thermische Leitfähigkeit aufweist.

5. Abgasführungsvorrichtung nach einem der vorstehenden Ansprüche, **dadurch gekennzeichnet, dass** das thermoelektrische Material stromabwärts eines Eintrittsbereichs des Abgases in die Abgasführungsvorrichtung sowie eines Bereichs (22) der ersten Fläche (18) mit einem Wärmeübergangswiderstand kleiner als einem vorbestimmten Schwellenwert mit einer höheren Majoritätsladungsträgerdichte versehen ist als im Bereich mit höherem Wärmeübergangswiderstand.

6. Verfahren zur Bildung eines thermoelektrischen Generators (17) mit einer Mehrzahl thermoelektrischer Module (16), die zwischen mit unterschiedlichen Temperaturen beaufschlagbaren Flächen (18, 21) angeordnet sind, **dadurch gekennzeichnet, dass** die thermoelektrischen Module (16) in Durchströmungsrichtung des Generators (17) so angeordnet werden, dass die am Strömungsaustritt des Generators angeordneten Module eine höhere Ladungsträgerdichte besitzen als die am Strömungseintritt angeordneten Module.

FIG. 1

EP 2 284 383 A2

FIG. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005005077 A1
- US PS960324 A
- DE 102006019282 A1